Europäisches Patentamt

European Patent Office

Office européen des brevets

(19)

(11) Veröffentlichungsnummer: **0 184 593**
**A1**

## (12) EUROPÄISCHE PATENTANMELDUNG

(21) Anmeldenummer: 84115450.3

(22) Anmeldetag: 14.12.84

(51) Int. Cl.⁴: **H 04 B 1/30, H 03 B 27/00,**
**H 03 D 1/22**

(43) Veröffentlichungstag der Anmeldung: **18.06.86**
**Patentblatt 86/25**

(84) Benannte Vertragsstaaten: **DE FR GB IT NL**

(71) Anmelder: **Deutsche ITT Industries GmbH,**
**Hans-Bunte-Strasse 19 Postfach 840, D-7800 Freiburg**
**(DE)**

(72) Erfinder: **Kappeler, Otmar, Dipl.-Ing.,**
**Zähringerstrasse 22, D-7844 Neuenburg (DE)**

(74) Vertreter: **Morstadt, Volker, Dipl.-Ing. et al, c/o Deutsche**
**ITT Industries GmbH Patent/Lizenzabteilung**
**Postfach 840 Hans-Bunte-Strasse 19,**
**D-7800 Freiburg/Brsg. (DE)**

(54) Generatorschaltung zur Erzeugung zweier um 90 grad phasenverschobener Sinussignale.

(57) Die Generatorschaltung erzeugt zwei um 90° phasenverschobene, frequenzvariable, Sinussignale (ac1, ac2) durch Heruntermischung der Ausgangsspannung eines Festfrequenzoszillators (co) und eines durchstimmbaren Oszillators (vo) mittels zweier als Mischer arbeitender Multiplizierer (m1, m2). Dabei ist das Frequenzsignal dem zweiten Multiplizierer (m2) über einen 90°-Phasenschieber (dp) zugeführt. Das Ausgangssignal der Multiplizierer (m1, m2) das die Summen- und die Differenzfrequenz ihrer Eingangssignale enthält, ist jeweils einem Tiefpaß (t1, t2) oder Bandpaß (b1, b2) zugeführt, der die Summenfrequenz bzw. Differenzfrequenz unterdrückt. Durch den 90°-Phasenschieber (dp) ist das Sinussignal (ac2) gegenüber dem Sinussignal (ac1) exakt um 90° in der Phase verschoben. Beim Durchstimmvorgang bleibt das am 90°-Phasenschieber (dp) anliegende Signal in der Frequenz stabil, während das den beiden Multiplizieren (m1, m2) direkt zugeleitete Ausgangssignal des durchstimmbaren Oszillators (vo) in der Frequenz verändert ist.

0184593

O. Kappeler 1

Fl 1232 EP
Sa/Be
12.Dezember 1984

<u>Generatorschaltung zur Erzeugung zweier um 90$^{\circ}$ phasen-</u>
<u>verschobener Sinussignale</u>

Die Erfindung bezieht sich auf eine Generatorschaltung
zur Erzeugung zweier gemeinsam frequenzvariabler, gegeneinander um exakt 90$^{\circ}$ phasenverschobener Sinussignale,
mit einem Festfrequenzoszillator, dessen Ausgang mit
dem Eingang eines 90$^{\circ}$-Phasenschiebers und mit dem ersten
Eingang eines analogen Multiplizierers verbunden ist,
und mit einem zweiten analogen Multiplizierer, dessen
erster Eingang mit dem Ausgang des 90$^{\circ}$-Phasenschiebers
verbunden ist, vergl. den Oberbegriff des Anspruchs 1.

Eine derartige Generatorschaltung ist in der Patentschrift EP-B1- 0 003 867 beschrieben. Bei dieser Anordnung stellt eine auf ein stereotonmoduliertes Trägersignal
eingerastete phasenverriegelte Schleife (= PLL-Schleife)
einen Festfrequenzoszillator dar, der einmal über einen
90$^{\circ}$-Phasenschieber und einmal direkt an je einem Multiplizierer liegt. Am jeweils zweiten Eingang der Multiplizierer liegt das stereotonmodulierte Trägersignal.
Die beiden Ausgangssignale der Multiplizierer stellen
zwei voneinander verschiedene Komponenten des Stereosignals dar und sind an hier nicht interessierende
Schaltungsteile zur endgültigen Erzeugung des rechten
und des linken Tonkanalsignals angeschlossen.

Der Anwendungsbereich der Erfindung liegt auf dem Gebiet
der analogen Quadraturmischung, das zwei gegeneinander
um 90$^{\circ}$ phasenverschobene Sinussignale erfordert. Ganz
besondere Anforderungen werden an derartige Quadraturmischschaltungen bei der direkten Demodulation von amplituden- oder frequenzmodulierten Trägersignalen
nach der "dritten Methode", auch Weafer, Tief-ZF- oder
Null-ZF-Verfahren genannt, bezüglich der Genauigkeit
der $90^{\circ}$-Phasenverschiebung bei zusätzlicher Frequenzdurchstimmbarkeit gestellt, da die Umsetzung auf eine Zwischenfrequenz entfällt und direkt vom Trägerfrequenzbereich
in den NF-Bereich umgesetzt wird, vergl. Meinke/Grundlach,
Taschenbuch der Hochfrequenztechnik, 2. Aufl., 1962,
Seiten 1311 bis 1313 und 1499. Schon ein Phasenfehler von
1%, der durch die Frequenzabhängigkeit des $90^{\circ}$-Phasen-
schiebers entstehen kann, verringert beispielsweise nach
der Offenlegungsschrift DE-A-23 58 288 bei amplitudenmodulierten Trägern den Rauschabstand auf 40 dB, was bei
Audioanwendungen bereits stört.

Aufgabe der in den Ansprüchen gekennzeichneten Erfindung
ist es daher, eine verbesserte Generatorschaltung für
zwei exakt $90^{\circ}$-phasenverschobene, in der Frequenz durchstimmbare Sinussignale anzugeben. Die Erfindung löst
diese Aufgabe, indem der $90^{\circ}$-Phasenschieber nicht mit dem
durchstimmbaren Oszillatorsignal, sondern mit einem
Festfrequenzsignal gespeist wird und die gewünschten
durchstimmbaren, um $90^{\circ}$ phasenverschobenen Sinussignale
durch Heruntermischung aus dem phasenverschobenen und
nichtphasenverschobenen Festfrequenzsignal sowie den
durchsteuerbaren Oszillatorsignal mittels zweier Mischer
und anschließender Siebung durch die jeweils ausgangsseitig angeschlossenen Tiefpässe, erzeugt werden.

Ein durch die Erfindung erreichter Vorteil ist darin
zu sehen, daß bei der Frequenzdurchstimmung die Frequenzabhängigkeit des $90^{\circ}$-Phasenschiebers ohne Einfluß
ist. Ein weiterer Vorteil besteht darin, daß der Abgleich der erforderlichen Kondensatoren oder der entsprechenden
Widerstände bei monolithischer Integration der Generatorschaltung auf dem Halbleiterkristall vorgenommen werden
kann ohne daß entsprechende externe Bauelemente anzuschließen sind, oder daß der Abgleich elektronisch durch
eine entsprechende Reaktanzschaltung durchführbar ist.
Durch die Integration ist zudem die HF-Einstrahlfestigkeit
der Schaltungsanordnung verbessert, denn die Strukturen
sind klein, eng benachbart und haben HF-mäßig keine
einstrahlempfindlichen äußeren Anschlüsse. Aufgrund
der Mischung und der Wegfilterung der Oberwellen ergibt
sich der weitere Vorteil, daß entweder das den ersten
Multiplizierer und den $90^{\circ}$-Phasenschieber speisende
Festfrequenzsignal oder das die beiden Multiplizierer
gemeinsam speisende durchstimmbare Oszillatorsignal auch
ein Signal mit Oberwellenanteilen, insbesondere ein
Rechtecksignal mit einem Puls-Pausen-Verhältnis von 1 : 1,
z.B. das Ausgangssignal eines Frequenzteilers, sein kann;
das jeweils andere speisende Signal darf dann keine
Oberwellen enthalten, muß also ein Sinussignal sein.

Generatorschaltungen nach der Erfindung sind auch für die
Verarbeitung niederfrequenter Trägerfrequenzen (Langwellen-, Mittelwellen-Rundfunk) monolithisch integrierbar,
denn die eigentliche $90^{\circ}$-Phasenverschiebung erfolgt bei
einer hohen Frequenz vor der Herabmischung, z.B. oberhalb
von 10 MHz. Bei dieser Frequenz sind RC-Gieder hoher Güte
aus Schichtwiderständen und Metall-Isolierschicht-Kondensatoren oder Reaktanzschaltungen von der Größe her leicht
integrierbar; dies gilt auch für die Tiefpaßrealisierung.

Eine besonders vorteilhafte Weiterbildung der erfindungsgemäßen Generatorschaltung ermöglicht außer der Verarbeitung der niederfrequenten Trägerfrequenzen auch die
Verarbeitung hochfrequenter Trägerfrequenzen , z.B. beim
Ultrakurzwellen-Rundfunk, indem die Summenfrequenzsignale
der Multiplizierer ausgenützt werden.

Oszillators erfolgt hierbei in quantisierten Frequenzsprüngen. Dies ermöglicht das gezielte Einstellen der
zu empfangenden Frequenzen oder Kanäle.

Eine besonders vorteilhafte Weiterbildung der erfindungsgemäßen Generatorschaltung ermöglicht außer der Verarbeitung der niederfrequenten Trägerfrequenzen auch die
Verarbeitung hochfrequenter Trägerfrequenzen , z.B. beim
Ultrakurzwellen-Rundfunk, indem die Summenfrequenzsignale
der Multiplizierer ausgenützt werden.

Die Erfindung wird nun anhand der Figuren der Zeichnung
näher erläutert.

Fig. 1 zeigt als Blockschaltbild ein Ausführungsbeispiel
der Generatorschaltung,
Fig. 2 zeigt als Blockschaltbild ein weiteres Ausführungsbeispiel mit Hauptoszillator und Frequenzteilern, und
Fig. 3 zeigt als Blockschaltbild ein Ausführungsbeispiel
mit Frequenzrasterung.

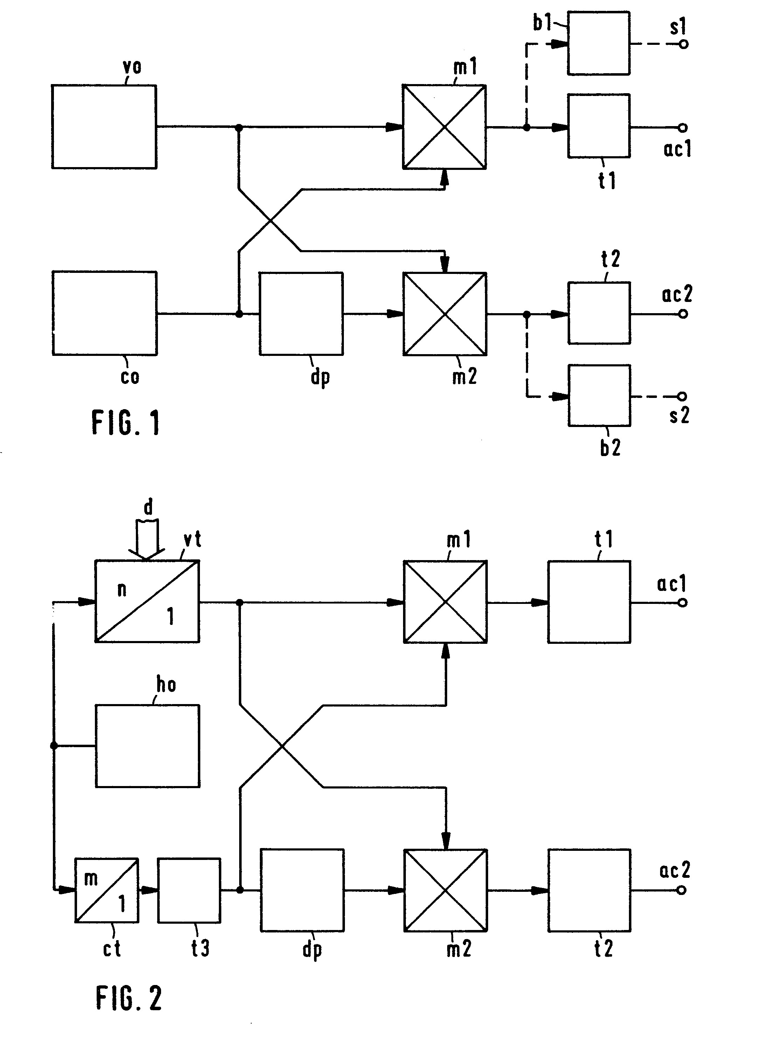

In Fig. 1 ist ein Ausführungsbeispiel einer erfindungsgemäßen Generatorschaltung in Form eines Blockschaltbilds dargestellt. Der Festfrequenzoszillator co ist
ausgangsseitig mit dem $90^{\circ}$-Phasenschieber dp und mit
dem ersten Eingang des ersten Multiplizierers m1 verbunden. Dessen zweiter Eingang ist mit durchstimmbaren
Oszillator vo verbunden. Der Ausgang des $90^{\circ}$-Phasen-
schieber dp liegt am ersten Eingang des zweiten Multiplizierers m2, dessen zweiter Eingang am Ausgang des
Oszillators vo und dessen Ausgang mit dem Eingang des
zweiten Tiefpasses t2 verbunden ist. Der Ausgang des
ersten Multiplizierers m1 ist mit dem Eingang des ersten
Tiefpasses t1 verbunden, an dessen Ausgangsklemme das
eine Sinussignal ac1 abnehmbar ist. Das andere Sinus-

O. Kappeler 1                    Fl 1232 EP

signal ac2 ist an der Ausgangsklemme des zweiten Tiefpasses t2 zu entnehmen.

Bei der oben erwähnten Weiterbildung der Erfindung liegt
der Ausgang des ersten Multiplizierers m1 am ersten
Bandpaß b1, an dessen Ausgangsklemme das erste sinusförmige Summenfrequenzsingnal s1 abnehmbar ist, und der
Ausgang des zweiten Multiplizierers m2 liegt am zweiten
Bandpaß b2, an dessen Ausgangsklemme das zweite sinusförmigen Summenfrequenzsignal s2 abnehmbar ist. Die Verbindung der beiden Bandpässe  b1, b2 mit den Multiplizierer
m1, m2 ist in Fig. 1 gestrichelt angedeutet.

Beträgt die Frequenz des Festfrequenzoszillators co
z.B. 30 MHz und die Frequenz des durchstimmbaren Oszillators vo z.B. 31 MHz, dann ergeben sich am Ausgang
der beiden Multiplizierer m1, m2 Frequenzgemische aus
der Summen- und Differenzfrequenz der Oszillatoren
co, vo. Im angesprochenen Beispiel beträgt die Summenfrequenz 61 MHz und die Differenzfrequenz 1 MHz. Durch
den 90$^{o}$-Phasenschieber dp ist die Ausgangsspannung
des zweiten Multiplizierers m2 gegenüber der Ausgangsspannung des ersten Multiplizierers m1 sowohl in der
Summenfrequenz als auch in der Differenzfrequenz um
genau 90$^{o}$ phasenverschoben. Da die obere Grenzfrequenz
der beiden Tiefpässe t1, t2 zwischen der Summenfrequenz
und der Differenzfrequenz liegt, werden durch die Tiefpässe t1, t2 die Summenfrequenzen unterdrückt, so daß
als Ausgangssignale nur die Differenzfrequenzen als
das eine Sinussignal ac1 und das andere Sinussignal
ac2 an der jeweiligen Ausgangsklemme auftreten, wobei
die gegenseitige Phasenverschiebung exakt 90$^{o}$ beträgt.

Für ein anderes Beispiel, bei dem zusätzlich die beiden
Bandpässe b1, b2 angeschlossen sind, schwingt der Festfrequenzoszillator co auf 44,4 MHz. Überstreicht der durchstimmbare Oszillator vo einen Frequenzbereich von 44,5
MHz bis 44,7 MHz, so liegt die Differenzfrequenz im Langwellen-Rundfunkbereich von 100 kHz bis 300 kHz. Überstreicht der durchstimmbare Oszillator vo einen Frequenzbereich von 44,9 MHz bis 45,9 MHz, so liegt die Differenzfrequenz im Mittelwellen-Rundfunkbereich von 500 kHz bis 1500 kHz. Überstreicht der durchstimmbare Oszillator vo einen Frequenzbereich von 44.6 MHz bis 65,6 MHz, so liegt die Summenfrequenz im Ultrakurzwellen-Rundfunkbereich (UKW-Bereich) von 89 MHz bis 110 MHz. Der Durchlaßbereich der Bandfilter b1, b2 muß in diesem Beispiel mindestens so groß wie der UKW-Bereich sein, die Bandfilter sollen aber die Differenzfrequenz und höhere Mischfrequenzen als die Summenfrequenzen unterdrücken.

In Fig. 2 ist ein weiteres Ausführungsbeispiel der Erfindung gezeigt. Gegenüber der Fig. 1 werden der Festfrequenzoszillator co und der durchstimmbare Oszillator vo durch einen Hauptoszillator ho ersetzt, der an einen Festfrequenzteiler ct mit dem nachgeschalteten dritten Tiefpaß t3 und an einen variablen Frequenzteiler vt angeschlossen ist. Das Ausgangssignal des dritten Tiefpasses t3 entspricht dem Ausgangssignal des Festfrequenzoszillators co und ist dem Eingang des $90^{\circ}$-Phasenschiebers dp und dem ersten Eingang des ersten Multiplizierers m1 zugeführt. Das Ausgangssignal des variablen Frequenzteilers vt, dessen ganzzahlige oder nichtganzzahlige Teilungszahl durch die Daten d einstellbar ist, entspricht dem Ausgangssignal des durchstimmbaren Oszillators vo und ist an den jeweiligen zweiten Eingang der Multiplizierer m1, m2 angeschlossen. Als Zahlenbeispiel sei angenommen, daß der Hauptoszillator ho bei 75 MHz schwingt. Das gibt am Ausgang des Festfrequenzteilers ct bei einer Teilungszahl 2,5 eine Ausgangsfrequenz von 30 MHz. Der variable Frequenzteiler vt ist über die Daten d auf eine Teilungszahl 2,4193 eingestellt. Seine Ausgangsfrequenz ist somit nahezu 31 MHz. Damit beträgt die Frequenz der beiden Sinussignale ac1, ac2 wie im ersten Beispiel 1 MHz bei einer Phasenverschiebung von exakt $90^{\circ}$.

O. Kappeler 1                    Fl 1232 EP

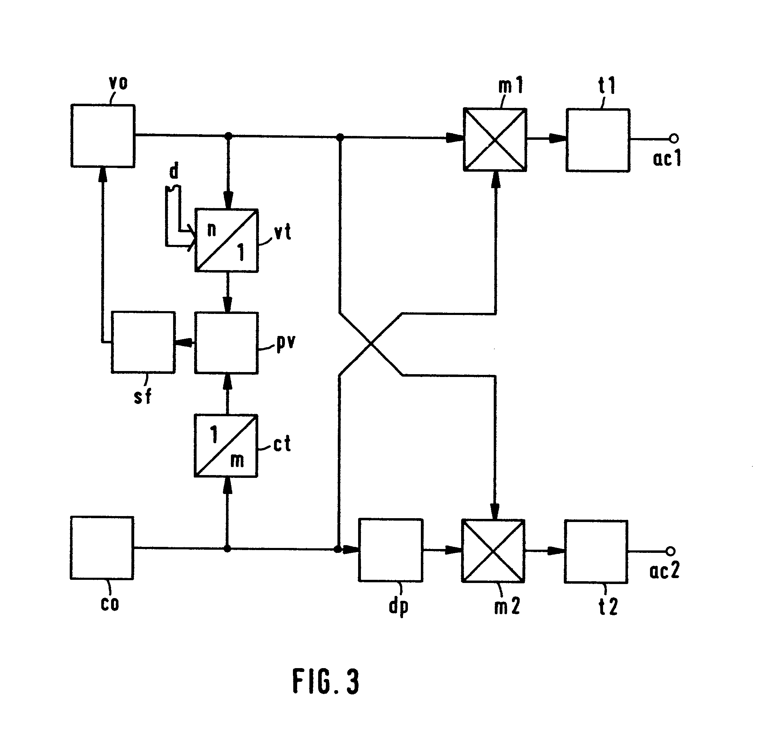

In Fig. 3 ist ein weiteres Ausführungsbeispiel der
Erfindung gezeigt. Der Festfrequenzoszillator co speist
mit seinem Ausgangssignal den $90^{\circ}$-Phasenschieber dp,
den ersten Eingang des ersten Multiplizierer m1 und
dem Festfrequenzteiler ct, dessen Teilungszahl m ist.
Der durchstimmbare Oszillator vo speist mit seinem Ausgangssignal den jeweils zweiten Eingang der beiden
Multiplizierer m1, m2 und den variablen Frequenzteiler
vt, dessen Teilungszahl n durch digitale Daten d einstellbat ist. Die Ausgangssignale der Frequenzteiler ct,
vt liegen jeweils an einem Eingang des Phasenvergleichers
pv, dessen Ausgangssiganl über das Schleifenfilter
sf dem Steuereingang des durchstimmbaren Oszillators
vo zugeleitet ist. An den Ausgang des ersten Multiplizierers m1 ist der erste Tiefpaß t1 angeschlossen,
dessen Ausgangssignal das erste Sinussignal ac1 ist.
An den Ausgang des zweiten Multiplizierers m2 ist der
zweite Tiefpaß t2 angeschlossen, dessen Ausgangssignal
das andere Sinussignal ac2 ist.

Ein einfaches Zahlenbeispiel zeigt die Funktion der
beschriebenen Schaltung. Der Festfrequenzoszillator
co schwingt mit einer Frequenz con 30 MHz. Die Teilungszahl m des Festfrequenzteilers ct soll 3000 sein, damit
ist die heruntergeteilte Festfrequenz 10 kHz. Für die
Frequenz des durchstimmbaren Oszillators vo sind 31 MHz
angenommen; damit ergibt sich aus der Differenzfrequenz
eine Frequenz von 1 MHz für die $90^{\circ}$-phasenverschobenen
Sinussignale ac1, ac2 am Ausgang der Generatorschaltung.
Das Oszillatorsignal von 31 MHz wird in seiner Frequenz
durch den variablen Frequenzteiler mit der Teilungszahl
n = 3100 geteilt. Das ergibt eine heruntergeteilte
Frequenz von 10 kHz für das durchstimmbare Oszillatorsignal. Auf der Frequenzebene von 10 kHz findet nun
im Phasenvergleicher pv der Phasenvergleich statt.

0184593

O. Kappeler 1                                    Fl 1232 EP

Weichen Frequenz oder Phase der beiden zu vergleichenden
Signale voneinander ab, so ändert der Phasenvergleicher
po sein Ausgangssignal je nach Betrag und Vorzeichen
der gemessenen Phasendifferenz zwischen seinen beiden
Eingangssignalen. Das Tiefpaßfilter mit geeigneter
Frequenzcharakteristik, daher Schleifenfilter sf genannt,
glättet das Ausgangssignal des Phasenvergleichers pv
und speist den Steuereingang des durchstimmbaren Oszillators vo. Wird mittels eines geeigneten Datenwortes d
die Teilungszahl n des variablen Frequenzteilers um
einen Schritt auf n = 3101 erhöht, so rastet die Phasenverriegelungsschleife den durchstimmenbaren Oszillator
vo bei einem Frequenzwert ein, der 10 kHz vom ursprünlichen abweicht, nämlich 31,010 MHz oder 30.09 MHz,
je nach Anschlußzuordnung am Phasenvergleicher pv.
Diese festen 10-kHz-Schritte bei der Durchstimmung sind
also die erwähnte Frequenzrasterung.

Die Realisierung des 90$^{\mathrm{o}}$-Phasenschiebers dp, der Tießpässe t1, t2, t3 und des Schleifenfilters sf erfolgt
beispielsweise mittels Reaktanzschaltungen oder monolithisch integrierbarer Widerstand-Kondensator-Kombinationen (= RC-Gieder), die aus Schichtwiderständen
und Metall-Isolierschicht-Kondensatoren bestehen und
in Verbindung mit Verstärker- und Pufferschaltungen
die gewünschte Frequenzcharakteristiken erzeugen. Derartige kompakte Anordnungen mit kurzen internen Verbindungsleitungen ohne äußere Anschlüsse stellen einen
induktionsarmen, verlustlosen Aufbau mit geringer Streukapazität dar, der einmal auch ein bis zwei Dekaden
oberhalb der Grenzfrequenz noch nahezu ideal arbeitet
und zum anderen gegen äußere Störsignale einstrahlfest
ist, sowie auch selbst nur minimal Störsignale abstrahlt.
Ein Berechnungsbeispiel für ein RC-Glied mit einer
Grenzfrequenz von 20 MHz ergibt für einen leicht integrierbaren Metall-Isolierschicht-Kondensator von 4 pF einen zuzuordnenden Schichtwiderstand von 2 k   , der ebenfalls leicht integrierbar ist.

Die Genauigkeit der Frequenzcharakteristik kann bei Reaktanzschaltungen über die Änderung der Einstellgrößen oder bei RC-Giedern, als frequenzbestimmenden Elementen, über einen individuellen Abgleichvorgang der Widerstände oder der Metall-Isolierschicht-Kondensatoren erreicht werden, indem Teilwiderstände oder Teilkondensatoren zu- oder abgeschaltet werden. Das kann durch bleibendes Auftrennen oder Anschließen von Verbindungsleitungen zwischen parallel geschalteten Teilelementen oder durch bleibendes Überbrücken oder Serienschalten von seriengeschalteten Teilelementen mittels Leiterbahnen erfolgen, z.B. mittels eines Lasers oder einer lokalen Überhitzungstechnik. Bei einer anderen Methode wird der Metallbelag der Metall-Isolierschicht- Kondensatoren durch einen Laserstrahl teilweise entfernt, so daß hiermit die Kapazität verkleinert werden kann. Schließlich ist noch ein programmierbarer Abgleich denkbar, wenn die Teilkondensatoren und Teilwiderstände durch elektronische Schalter, wie Transistoren, zu und abschaltbar sind, wobei die Schalterstellungen beliebig veränderbar sind.

Der $90^{\circ}$-Phasenschieber kann auch als digitaler $90^{\circ}$-Phasenschieber realisiert werden. Ihm wird außer dem Festfrequenzsignal, das als Rechtecksignal mit einem Puls-Pausen-Verhältnis von vorzugsweise 1 : 1 ausgebildet ist, ein dazu phasenstarres weiteres Rechtecksignal mit der vierfachen Frequenz des Festfrequenzsignals und einem Puls-Pausen-Verhältnis von vorzugsweise 1 : 1 zugeführt. Mittels logischer Gatter werden die beiden Rechtecksignale miteinander   so verknüpft, daß das Ausgangssignal des $90^{\circ}$-Phasenschiebers um $90^{\circ}$ gegenüber dem Festfrequenzsignal verschoben ist.

O. Kappeler 1                    Fl 1232 EP

Eine optimale Ausführung der erfindungsgemäßen Generatorschaltung geht nicht nur von möglichst gleichen elektrischen Kenndaten für die beiden Signalwege der Sinussignale ac1, ac2 oder Summenfrequenzsignale s1, s2 aus,
sondern versucht bei der Integration die beiden Signalwege
möglichst spiegelbildlich auszuführen, um guten Gleichlauf
zu erreichen.

0184593

O. Kappeler 1

Fl 1232 EP
Sa/Be
12.Dezember 1984

Patentansprüche

1. Generatorschaltung zur Erzeugung zweier gemeinsam
frequenzvariabler, gegeneinander um exakt 90° phasenverschobener Sinussignale (ac1, ac2)
   - mit einem Festfrequenzoszillator (co), dessen
     Ausgang mit dem Eingang eines 90°-Phasenschiebers
     (dp) und mit dem ersten Eingang eines analogen
     Multiplizierers (m1) verbunden ist, und
   - mit einem zweiten analogen Multiplizierer (m2),
     dessen erster Eingang mit dem Ausgang des 90°-Phasenschiebers (dp) verbunden ist,
   gekennzeichnet durch folgende Merkmale:
   - ein durchstimmbarer Oszillator (vo) speist den
     jeweils zweiten Eingang des ersten Multiplizierers
     (m1) und des zweiten Multiplizierers (m2),
   - der Ausgang des ersten Multiplizierers (m1) ist
     an einen ersten Tiefpaß (t1) angeschlossen, dessen
     Ausgangssignal das eine Sinussignal (ac1) ist,
   - der Ausgang des zweiten Multiplizierers (m2) ist
     an einen zweiten Tiefpaß (t2) angeschlossen, dessen
     Ausgangssignal das andere Sinussignal (ac2) ist,
     und
   - die obere Grenzfrequenz der Tiefpässe (t1, t2)
     liegt zwischen der Summe und der Differenz der
     Frequenzen des Festfrequenzoszillators (co) und
     des Oszillators (vo).

2. Generatorschaltung nach Anspruch 1, dadurch gekennzeichnet, daß der abstimmbare Oszillator (vo) und
der Festfrequenzoszillator (co) mittels eines einzigen Hauptoszillators (ho) derart realisiert sind,

O. Kappeler 1                                    Fl 1232 EP

daß diesem für den Festfrequenzoszillator (co) ein
Festfrequenzteiler (ct) und für den durchstimmbaren
Oszillator (vo) ein variabler Frequenzteiler (vt),
dessen Teilungszahl durch digitale Daten (d) bestimmt
ist, jeweils nachgeschaltet ist und daß dem Festfrequenzteiler (ct) ein dritter Tiefpaß (t3) folgt,
dessen Grenzfrequenz unterhalb der dreifachen Ausgangssignalfrequenz des Festfrequenzteilers (ct) liegt.

3. Generatorschaltung nach Anspruch 1 oder 2, dadurch
gekennzeichnet, daß der $90^{\circ}$-Phasenschieber (dp)
und/oder die Tiefpässe (t1, t2, t3) jeweils mindestens
einen Metall-Isolierschicht-Kondensator als Teil einer
Widerstand-Kondensator-Kombination (= RC-Glied) oder
einer Reaktanz-Schaltung mit Verstärkern oder Stromquellen enthalten.

4. Generatorschaltung nach Anspruch 3, dadurch gekennzeichnet, daß der $90^{\circ}$-Phasenschieber und/oder die
Tiefpässe (t1, t2, t3) durch zu- oder abschaltbare Teilkondensatoren oder Teilwiderstände abgleichbar sind.

5. Generatorschaltung nach Anspruch 4, dadurch gekennzeichnet, daß der Abgleich durch Auftrennen oder
Herstellen von Shuntverbindungen über mindestens
einen seriengeschalteten Teilkondensator und/oder
Teilwiderstand oder durch Auftrennen oder Herstellen
einer leitenden Verbindung zwischen parallelgeschalteten bzw. parallelzuschaltenden Teilkondensatoren
und/oder Teilwiderständen endgültig vorgenommen ist.

6. Generatorschaltung nach Anspruch 4, dadurch gekennzeichnet, daß Teilkondensatoren und/oder Teilwiderstände durch elektronische Schalter, z.B. Transistoren,
zu- oder abschaltbar sind.

O. Kappeler 1                    Fl 1232 EP

7. Generatorschaltung nach einem der Ansprüche 1 bis 6, dadurch gekennzeichnet, daß der erste und der zweite Tiefpaß (t1, t2) in ihrer Frequenzcharakteristik identisch sind.

8. Generatorschaltung nach einem der Ansprüche 1 bis 3, gekennzeichnet durch folgende Merkmale:

- der 90$^O$-Phasenschieber (dp) ist ein digitaler 90$^O$-Phasenschieber,
- das Festfrequenzsignal ist ein Rechtecksignal mit einem Puls-Pausen-Verhältnis von vorzugsweise 1:1, und
- der digitale 90$^O$-Phasenschieber enthält logische Gatter zur Verknüpfung des Rechtecksignals und eines weiteren dazu phasenstarren Rechtecksignals mit der vierfachen Frequenz des Rechtecksignals und mit einem Puls-Pausen-Verhältnis von vorzugsweise 1 : 1.

9. Generatorschaltung nach einem der Ansprüche 1 bis 8, dadurch gekennzeichnet, daß für sinusförmige Ansteuersignale, welche die beiden Multiplizierer (m1, m2) speisen, am Ausgang des ersten Multiplizierers (m1) ein erster Bandpaß (b1) und am Ausang des zweiten Multiplizierers (m2) ein zweiter Bandpaß (b2) angeschlossen ist, daß die Mittenfrequenz der beiden Bandpässe (b1, b2) die Summe, ihre untere Grenzfrequenz zwischen der Summe und der Differenz und ihre obere Grenzfrequenz zwischen der Summe und der doppelten Summe der Frequenz des Festfrequenzoszillators (co) und des Oszillators (vo) liegt und daß das Ausgangssignal des ersten Bandpasses (b1) das erste sinusförmige Summenfrequenzsignal (s1) und das Ausgangssignal des zweiten Bandpasses (b2) das zweite sinusförmige Summenfrequenzsignal (s2) ist.

O. Kappeler 1                                    Fl 1232 EP

10. Generatorschaltung nach Anspruch 1 oder nach einem
    der Ansprüche 3 bis 9, dadurch gekennzeichnet,
    - daß das Ausgangssignal des Festfrequenzoszillators
      (ct) am Eingang des Festfrequenzteilers (ct)
      liegt,
    - daß das Ausgangssignal des durchstimmbaren Oszillators (vt) am Eingang des variablen Frequenzteilers (vt) liegt, dessen Teilungszahl (n) durch
      digitale Daten (d) bestimmt ist,
    - daß das Ausgangssignal des Festfrequenzteilers
      (ct) den ersten Eingang eines Phasenvergleichers
      (pv) speist, dessen Ausgangssignal über ein Schleifenfilter (sf) am Steuereingang des variablen
      Oszillators (vo) liegt,
    - und daß das Ausgangssignal des variablen Frequenzteilers (vt) den zweiten Eingang des Phasenver-
      gleichers (pv) speist.

84 11 5450.3
0184593

FIG. 1

FIG. 2

84 11 5450·3
0184593

FIG. 3

0184593

Nummer der Anmeldung

**Europäisches Patentamt**

## EUROPÄISCHER RECHERCHENBERICHT

EP 84 11 5450

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | DE-A-2 828 224 (LICENTIA PATENT-VERWALTUNGS GMBH) * Figur 1, Anspruch 1 * | 1 | H 04 B 1/30<br>H 03 B 27/00<br>H 03 D 1/22 |
| Y | EP-A-0 122 657 (PHILIPS) * Figur 1; Zusammenfassung * | 1 | |
| A | US-A-3 999 130 (N.L. WHISLER) * Figur 3, Zusammenfassung * | | |
| A | EP-A-0 124 949 (PHILIPS) * Figur 1 * | | |
| A | DE-A-2 358 288 (STANDARD ELEKTRIK LORENZ) * Figur 1 * | | RECHERCHIERTE SACHGEBIETE (Int. Cl.4) |
| A | DE-A-2 657 170 (PHILIPS) * Figur 1 * | | H 04 B 1/30<br>H 03 B 27/00<br>H 03 D 1/22<br>H 03 D 1/24<br>H 03 D 7/16 |

Der vorliegende Recherchenbericht wurde für alle Patentansprüche erstellt.

| Recherchenort BERLIN | Abschlußdatum der Recherche 03-07-1985 | Prüfer BREUSING J |
|---|---|---|